# EUROPEAN PATENT APPLICATION

(11) **EP 1 266 982 A2**
(43) Date of publication of application: **18.12.2002**
(21) Application number: 02251915.1
(22) Date of filing: 18.03.2002
(51) Int. Cl.: C30B 29/16, C30B 9/00

(54) **Method for production of zinc oxide single crystal**

(30) Priority: 12.06.2001 JP 2001177499
(71) Applicant: National Institute of Advanced Industrial Science and Technology, Tokyo 100-8921 (JP)
(72) Inventor: Oka,Kunihiko National Institute AIST,, 305-8568 Ibaraki (JP)
(74) Representative: Smith, Norman Ian

(57) **Abstract**

A method for producing a transparent white large single crystal of zinc oxide includes the steps of mixing zinc oxide as a solute with molybdenum oxide as a solvent, heating the resultant mixture till fusion, and thereafter keeping the temperature of the produced melt intact or lowering the temperature thereof, thereby inducing deposition and growth of a microcrystal represented by the general formula, ZnO, on a seed crystal (12) or substrate.

## Description

This invention relates to a method for the production of a zinc oxide single crystal that is usable for the production of a single crystal by the top-seeded solution growth method (TSSG method) and the traveling-solvent floating-zone method (TSFZ method) of zinc oxide and for the production of a single crystal by the liquid-phase epitaxy growth method.

### Description of the Prior Art:

Zinc oxide is an interesting substance that, though an oxide in entity, is capable of giving rise to a direct transition type semiconductor manifesting a band gap of 3.3 eV. It is a material that can be expected to find utility as a blue ultraviolet emission material. It also exhibits piezoelectricity, fluorescence and photoconductivity and combines diverse functions. In recent years, this substance has been attracting attention as a magnetic semiconductor and has been promising more extensive utility. It, therefore, is required to form a large single crystal of high quality. Since the conventional hydrothermal synthesis method or slow-cooling method fails to produce a large single crystal long in an expected direction of crystal axis and necessitates a long time for the production of a crystal, the top-seeded solution growth method (TSSG method) and the traveling-solvent floating-zone method (TSFZ method) using boron oxide and vanadium oxide as solvents have been proposed with a view to overcoming the drawbacks of the conventional methods (Japanese Patent Application No. 2000-394927).

The single crystal which is produced by the top-seeded solution growth method (TSSG method) and the traveling-solvent floating-zone method (TSFZ method) using boron oxide and vanadium oxide as described above, however, does not assume the transparent white color which is inherent in zinc oxide but is found to be colored in brown to yellow. Vanadium oxide is designated as a toxic substance and, therefore, is at a disadvantage in demanding careful handling.

An object of this invention is to provide a method for producing a transparent white zinc oxide without requiring use of vanadium oxide as a solvent.

The method for the production of a zinc oxide single crystal according to this invention comprises the steps of mixing zinc oxide as a solute with molybdenum oxide as a solvent to form a mixture, thermally fusing the mixture to produce a melt, and keeping a temperature of the melt intact or lowering the temperature of the melt, thereby allowing a microcrystal represented by the general formula, ZnO, to be deposited and grown on a seed crystal or substrate.

The method described above embraces a method wherein the mixture is interposed between a raw material feed rod of zinc oxide and the seed crystal before the thermally fusing step and the thermally fusing step is taken at not less than 1060°C to form a floating melt zone, and further comprising a step of moving the floating melt zone toward the raw material feed rod, thereby inducing deposition of a single crystal on said seed crystal.

The solute is allowed to contain one or more foreign elements selected from the group consisting of Li, Na, K, Cu, Ag, N, P. As, Cr, Al, Bi, Sb, Co, Fe, Ni, Ti, Mn, V and Pr.

This invention is capable of depositing and growing a ZnO single crystal on a seed crystal by the top-seeded solution growth method (TSSG method) or the traveling-solvent floating-zone method (TSFZ method) using the melt and is also capable of producing a ZnO single crystal membrane on a substrate by the liquid-phase epitaxy growth method which comprises immersing the substrate in the melt.

It is further capable of producing from zinc oxide and molybdenum oxide that have no appreciably high toxicity transparent white single crystal of high quality grown in an arbitrary size in a required direction depending on the seed crystal.

The other objects and characteristic features of this invention will become apparent from the detailed description to be given hereinbelow based on the annexed drawings in which:-.
FIG. 1 is a phase diagram of the ZnO-MoO₃ system,
FIG. 2 is a cross section of a single crystal growth device used in Examples 1 and 2 of this invention, and
FIG. 3 is a schematic diagram of a single crystal production device resorting to the traveling-solvent floating-zone method (TSFZ) experimented in Example 3.

First, the principle of this invention will be described.

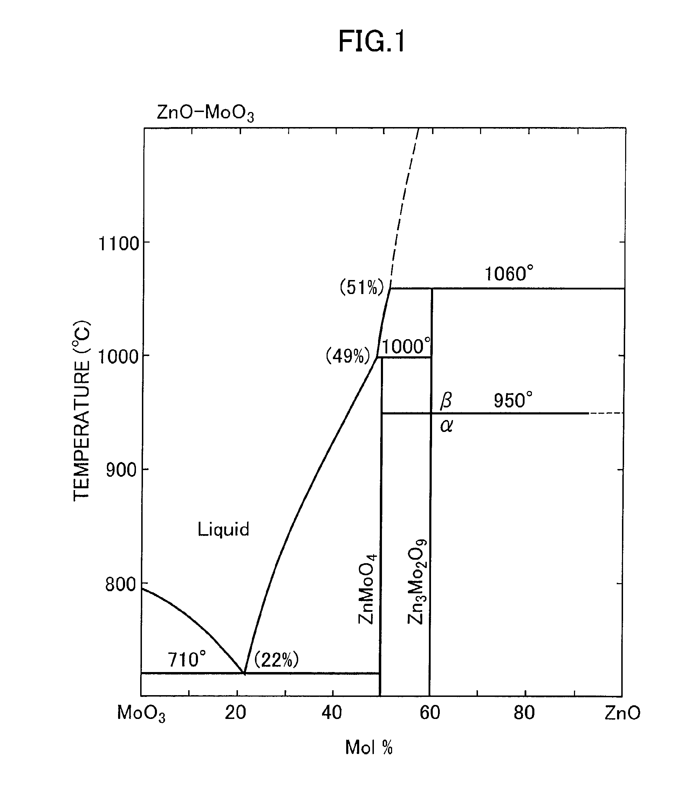

FIG. 1 is a phase diagram of the ZnO-MoO₃ system (R. Kohlmuller and J. P. Faurie, Bull. Soc. Chim. Fr., (1968) 4381).

A liquidus line exists in a composition of 51 to 100 mol% of ZnO and 49 to 0 mol% of MoO₃. The raw material for the mixed composition between these oxide melts at any temperature falling in the liquidus line. When the temperature of the molten raw material is gradually lowered, the composition of the molten raw material is continuously shifted along the liquidus line toward the MoO₃ side and the ZnO is gradually precipitated as a solid phase.

When the composition is further shifted to the left from the point of 51 mol% of ZnO and 49 mol% of MoO₃, ZnO is no longer precipitated and Zn₃Mo₂O₉ is precipitated as a solid phase. No ZnO can be precipitated and grown outside the range of composition mentioned above. When the mixed composition in this phase diagram is made to incorporate therein a small quantity of a certain foreign element, the same solid solution of ZnO is gradually precipitated as a solid phase so long as the phase diagram is not characteristically varied. It is conceivable to use boron oxide and vanadium oxide for this incorporation with a view to lowering the temperature for the production of a crystal, thereby repressing particularly the vaporization of ZnO, if only to a slight extent. So long as the quantity of such oxides to be incorporated is not more than 10% by weight based on the quantity of the solution contemplated by this invention, the incorporation is not found to pose any problem.

ZnO is known to have the characteristic properties thereof conspicuously varied by the incorporation therein of a foreign element. The ZnO compounds incorporating therein a foreign element, such as Li, Na, K, Cu, Ag, N, P, As, Cr, Al, Bi, Sb, Co, Fe, Ni, Ti, Mn, V or Pr, in a proportion of not more than several % have been heretofore utilized in the production of p type semiconductors, magnetic semiconductors, conductivity controllers, varistors, etc.

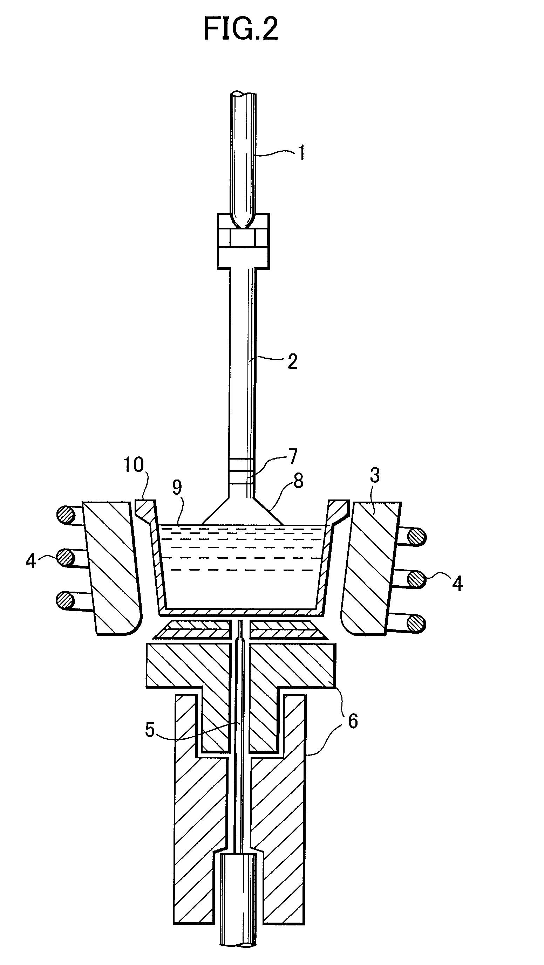

In the case of a solution incorporating therein a foreign element in particular, by the use of a top-seeded solution growth device depicted in FIG. 2 which will be specifically described hereinbelow, for example, a ZnO solid solution single crystal which has the added foreign element mixed homogeneously therein can be produced by establishing in a crucible a temperature environment furnished with a temperature gradient such that the bottom part of the crucible has a slightly higher temperature than the surface of the solution for the growth of a crystal, placing in the bottom part of the crucible a ZnO block incorporating therein a required quantity of the added element, and keeping the solution at a fixed temperature meanwhile pulling and growing the crystal, thereby causing the block in the bottom part of the crucible to be melted in proportion as the part thereof is spent for the growth, enabling the composition of the solution to remain intact constantly, and consequently permitting the added element to be homogeneously mixed in the produced single crystal.

In this invention, a ZnO single crystal grown from a solution which is formed basically of zinc oxide and molybdenum oxide is made to form a finished product deposited on the same ZnO or on a seed crystal having a lattice constant and a melting point approximate closely thereto, or a ZnO single crystal membrane similarly derived is made to grow on a substrate.

This invention, as described above, proposes a method for the production of a ZnO single crystal, comprising the steps of mixing zinc oxide as a solute with molybdenum oxide as a solvent, heating the resultant mixture to produce a melt, keeping the produced melt at a fixed temperature or cooling it to a lowered temperature, and consequently inducing deposition and growth of a microcrystal represented by the general formula, ZnO, on a seed crystal or on a substrate. Then, by the top-seeded solution growth method (TSSG) or the traveling-solvent floating-zone method (TSFZ) using the melt, it is made possible to have a ZnO single crystal deposited and grown on a seed crystal and by the liquid-phase epitaxy growth method which consists in immersing a substrate in the melt, it is made possible to produce a ZnO single crystal membrane on the substrate. The mode in which the traveling-solvent floating-zone method (TSFZ), for example, is adopted is as follows.

A single crystal can be deposited on a seed crystal by mixing zinc oxide as a solute with molybdenum oxide as a solvent to form a fixture, interposing the mixture between a raw material feed rod of zinc oxide and the seed crystal, heating the mixture to not lower than 1060°C to produce a melt that forms a floating melt zone, and moving the floating melt zone toward the raw material feed rod, thereby inducing the deposition of a single crystal on the seed crystal.

Now, this invention will be described specifically below with reference to working examples. It should be noted, however, that this invention is not limited to the working examples.

### Example 1:

A ZnO single crystal was produced by the top-seeded solution growth method (TSSG method). The single crystal growth device used for this production is illustrated in FIG. 2. Referring to FIG. 2, 1 denotes a pulling shaft, 2 a platinum shaft, 3 a heat insulator, 4 a RF heating coil, 5 a thermocouple, 6 a crucible support, 7 a seed crystal, 8 a grown single crystal, 9 a starting raw material, and 10 a platinum crucible.

ZnO and MoO₃ were mixed at a molar ratio of 54:46. In a platinum crucible 10 measuring 45 mm in diameter and 30 mm in height and concurrently serving as a heater element, 100 g of the produced mixture was placed and heated to about 1150°C by the induction heating method using the RF heating coil 4 till solution. Then, the ZnO single crystal 7 as a seed crystal was brought into contact with the surface of the melt. When the temperature of the melt was gradually lowered, a ZnO microcrystal was deposited little by little on the interface of the melt contiguous with the seed crystal which had the lowest temperature in the melt and crystallized and grown on the seed crystal 7. The single crystal S grown as described above was gradually pulled up from the melt. Thus, the pulling of the grown single crystal was carried out simultaneously with the lowering of the temperature of the melt. As regards the conditions for the production, the speed of pulling the ZnO single crystal was in the range of 0.5 ∼ 1.0 mm/h, the temperature lowering speed of the melt was in the range of 2 ∼ 5°C/h, the rotational frequency of crystal was in the range of 15 ∼ 30 rpm, and the atmosphere was open air. A transparent white ZnO single crystal measuring 20 × 22 × 3 mm could be obtained in a production time of 6 hours.

### Example 2:

A ZnO single crystal was produced by the top-seeded solution growth method (TSSG method) using the same device as in Example 1.

ZnO and MoO₃ were mixed at a molar ratio of 54:46 and the resultant mixture was made to add V₂O₅ and B₂O₃ each in an amount of 5 g for adjustment of the crystal growth temperature. In the platinum crucible 10, 110 g of the finally formed mixture was placed and subjected to the conditions for production, i.e. the pulling speed in the range of 0.5 ∼ 1.0 mm/h, the temperature lowering speed for the melt in the range of 2 ∼ 5°C/h, the rotational frequency of crystal in the range of 15 ∼ 30 rpm, and the atmosphere of open air. Thus, a yellowish white ZnO single crystal measuring 20 × 20 × 3 mm could be obtained in a production time of 6 hours.

### Example 3:

A ZnO single crystal was produced by the traveling-solvent floating-zone method (TSFZ method).

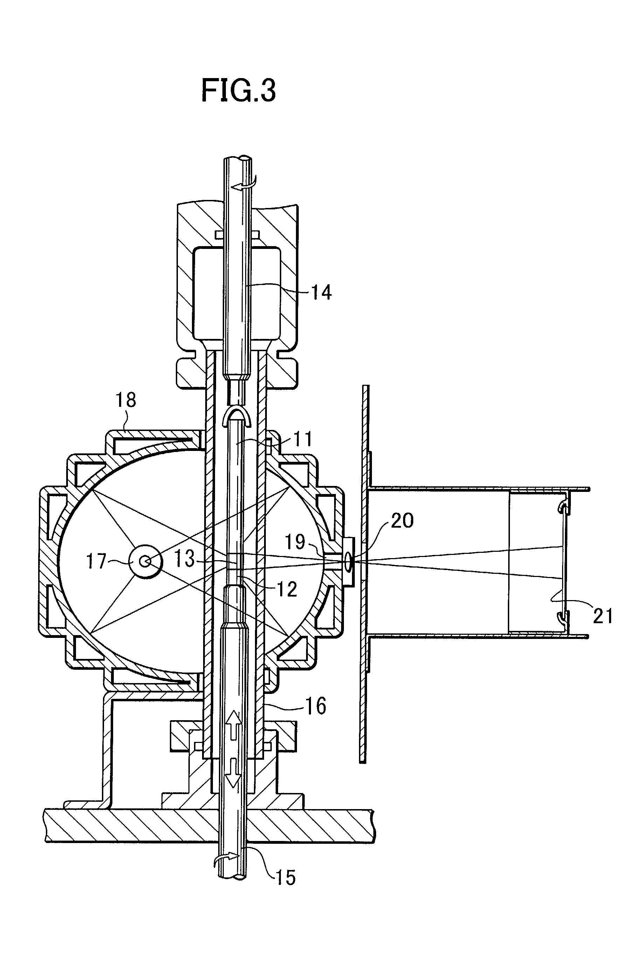

A floating zone single crystal production device used for the production is illustrated in FIG. 3. Referring to FIG. 3, 11 denotes a raw material feed rod, 12 a seed crystal, 13 a melt zone (solvent), 14 and 15 each a rotary shaft, 16 a quartz tube, 17 a halogen lamp, 18 an ellipsoidal mirror, 19 an inspection window, 10 a lens, and 21 an inspection screen.

A ZnO powder was compressed in a pressure molder to form a round bar measuring 6 mm in diameter and 7 cm in length. This round bar was homogeneously fired at 1400°C for15 hours to obtain the ZnO raw material feed rod 11.

A powder obtained by mixing ZnO and MoO₃ at a molar ratio of 54:46 was fired at 750°C for 15 hours. A pressure molder was used to compress the fired powder to form a round bar measuring 6 mm in diameter. The round bar was homogeneously fired at 800°C for 15 hours to obtain a solvent. Thereafter, the solvent in the shape of a round bar was cut radially to form discs and these discs were fused to a ZnO raw material feed rod.

The cylindrical bar specimen having the solvent fused to the leading end of the ZnO single crystal was fixed to the upper sample rotary shaft 14 in the floating zone single crystal production device adopting the infrared heating method. A fired ZnO feed rod was similarly fixed as a seed crystal 12 to the lower rotary shaft 15. Incidentally in this case, the seed crystal 12 and the ZnO raw material feed rod 11 having the solvent fused thereto were set so as not to deviate from the rotary shaft. The solvent mentioned above was thermally fused by the use of the infrared ray from the halogen lamp 17. Subsequently, the seed crystal was brought into contact with the molten solvent and, by virtue of the surface tension of the liquid, the molten solvent was kept between the raw material supply rod and the seed crystal. Thereafter, the raw material feed rod and the seed crystal were rotated at 30 rpm in the mutually opposite directions.

Further, the molten solvent was moved at a speed of 0.5 mm/hr in the direction of the raw material feed rod, namely in the upward direction, to induce growth of a ZnO single crystal on the seed crystal.

As a result, a transparent white ZnO crystal of the shape of a cylinder measuring 4 mm in diameter and 20 mm in length was obtained. This crystal was formed of several grains because the fired bar was used as the seed crystal.

### Example 4:

A ZnO single crystal was produced by the liquid-phase epitaxy growth method using the same device as in Example 1.

ZnO and MoO₃ were mixed at a molar ratio of 54:46. A platinum crucible 10 measuring 45 mm in diameter and 30 mm in height and concurrently serving as a heater element, 100 g of the produced mixture was placed and heated to about 1150°C by the inducting heating method using a RF heating coil 4 till fusion. A ZnO single crystal substrate or a sapphire substrate was brought into contact with the surface of the consequently produced melt, left immersed in the meld for 5 minutes, and then pulled up to produce a ZnO single crystal by the liquid-phase epitaxy growth method.

### Example 5:

A Li-added ZnO solid solution single crystal was produced by using the same device as in Example 1, setting the position of the peripheral edge part of the platinum crucible 10 at a height of 1 ∼ 2 cm from the upper edge of the RF heating coil 4, keeping the bottom part of the crucible at a higher temperature than the surface of the melt, and keeping the melt at a fixed temperature. The starting raw material was prepared by mixing ZnO, MoO₃, and Li₂CO₃ at a molar ratio of 54:45.5:0.5. The resultant mixture was placed in the platinum crucible and melted therein. Separately, 10 g of a mixture produced by mixing ZnO and Li₂CO₃ at a molar ratio of 99:1 was compressed in a pressure molder to obtain several discs measuring 10 mm in diameter and about 5 mm in thickness. These discs were fired at 1400°C for 15 hours. The fired blocks were placed in the molten starting raw material, allowed to sink to the bottom part of the crucible, and left stabilizing for 1 ∼ 2 hours. Thereafter, the seed crystal 7 was brought into contact with the surface of the liquid and, with the melt kept at a fixed temperature, subjected to the conditions for production, i.e. the pulling speed of the ZnO single crystal 8 in the range of 0.5 ∼ 1.0 mm/h, the rotational frequency of crystal in the range of 15 ∼ 30 rpm, and the atmosphere of open air. Thus, white ZnO solid solution single crystal measuring 15 × 15 × 3 mm could be obtained in a production time of 6 hours.

By adopting the method for production according to this invention, it is made possible to obtain a single crystal in a transparent white color that is inherent in zinc oxide as described above.

## Claims

1. A method for the production of a zinc oxide single crystal, comprising:
a step of mixing zinc oxide as a solute with molybdenum oxide as a solvent to form a mixture,
a step of thermally fusing the mixture to produce a melt, and
a step of keeping a temperature of the melt intact or lowering the temperature of the melt, thereby inducing deposition and growth of a microcrystal represented by the general formula, ZnO, on a seed crystal (12) or substrate.

2. The method according to claim 1, wherein the mixture is interposed between a raw material feed rod (11) of zinc oxide and the seed crystal (12) before the thermally fusing step and the thermally fusing step is taken at not less than 1060°C to form a floating melt zone (13), and further comprising a step of moving the floating melt zone toward the raw material feed rod, thereby inducing deposition of a single crystal on said seed crystal.

3. The method according to claim 1, wherein a mixing ratio of the solute to the solvent is in the range of 99.9 ∼ 51 mol% vs. 0.1 ∼ 49 mol%.

4. The method according to claim 2, wherein a mixing ratio of the solute to the solvent is in the range of 99.9 ∼ 51 mol% vs. 0.1 ∼ 49 mol%.5.

5. The method according to claim 1, wherein the solute contains a small quantity of a foreign element.

6. The method according to claim 2, wherein said zinc oxide contains a small quantity of a foreign element.

7. The method according to claim 5, wherein the foreign element is one or more members selected from the group consisting of Li, Na, K, Cu, Ag, N, P, As, Cr, Al, Bi, Sb, Co, Fe, Ni, Ti, Mn, V, and Pr.

8. The method according to claim 6, wherein the foreign element is one or more members selected from the group consisting of Li, Na, K, Cu, Ag, N, P, As, Cr, Al, Bi, Sb, Co, Fe, Ni, Ti, Mn, V, and Pr.
